# EUROPÄISCHE PATENTSCHRIFT

(11) **EP 3 184 965 B1**
(45) Veröffentlichungstag und Bekanntmachung des Hinweises auf die Patenterteilung: **24.06.2020**
(21) Anmeldenummer: 16200893.2
(22) Anmeldetag: 28.11.2016
(51) Int. Cl.: G01C 21/34, B60L 3/12, B60L 58/12

(54) **VERFAHREN ZUM ANPASSEN EINER REICHWEITENPRÄDIKTION EINES KRAFTFAHRZEUGS ANHAND VON UMGEBUNGSBEDINGUNGEN UND KRAFTFAHRZEUG**
METHOD FOR ADAPTING A RANGE PREDICTION OF A MOTOR VEHICLE ON THE BASIS OF ENVIRONMENTAL CONDITIONS AND MOTOR VEHICLE
PROCÉDÉ D'ADAPTATION D'UNE PRÉDICTION DE PORTÉE D'UN VÉHICULE AUTOMOBILE AU MOYEN DE CONDITIONS ENVIRONNEMENTALES ET VÉHICULE AUTOMOBILE

(30) Priorität: 24.12.2015 DE 102015016975
(43) Veröffentlichungstag der Anmeldung: 28.06.2017
(73) Patentinhaber: AUDI AG, 85045 Ingolstadt (DE)
(72) Erfinder: Schuller, Florian, 85737 Ismaning (DE); Klimesch, Michael, 85057 Ingolstadt (DE); Haubner, Florian, 85049 Ingolstadt (DE)

(56) Entgegenhaltungen:
- DE-A1-102009 048 821
- DE-A1-102011 116 115
- DE-A1-102013 202 303
- DE-A1-102014 118 118

## Beschreibung

Die Erfindung betrifft ein Verfahren zum Anpassen einer Reichweitenprädiktion eines Kraftfahrzeugs und ein Kraftfahrzeug.

Eine maximal verfügbare Reichweite insbesondere eines elektrisch angetriebenen Kraftfahrzeugs, das auch als Elektrofahrzeug bezeichnet wird, hängt stark von Umweltbedingungen ab und kann sich daher schlagartig verändern. Steht beispielsweise ein Elektrofahrzeug im Sommer bei einer Außentemperatur von 30 °C in einer kühleren Garage, ermittelt die Reichweitenprädiktion des Kraftfahrzeugs auf der Grundlage der Garagentemperatur eine systematisch zu hohe Reichweite. Sobald das Kraftfahrzeug die Garage verlässt, wird - allerdings mit erheblicher zeitlicher Verzögerung - ein wirklicher Energiebedarf für eine dauerhafte Kühlung des Kraftfahrzeuginnenraums erkannt, und die prognostizierte Reichweite nimmt abrupt ab. Da ein Temperatursensor des Kraftfahrzeugs, der zur Ermittlung der für die Reichweitenprädiktion herangezogenen Außentemperatur verwendet wird, am Kraftfahrzeug geschützt verbaut ist, vergeht eine vergleichsweise lange Totzeit von beispielsweise zwei Minuten, bis die Reichweitenprädiktion angepasst ist. Die Anpassung wird dem Fahrer des Kraftfahrzeugs daher verzögert zur Verfügung gestellt und steht somit nicht mehr in unmittelbar erkennbarem Zusammenhang mit dem Verlassen der Garage. Problematisch ist weiterhin, dass zur Anpassung der Reichweitenprädiktion typischerweise herangezogene Temperaturgradienten auch unter anderen Bedingungen auftreten, wobei es insbesondere im Sommer mit umgebungsabhängig besonders stark differierenden Temperaturen zu gehäuften Fehlanpassungen der Reichweitenprädiktion kommen kann.

DE 10 2013 202 303 A1 offenbart, dass einer berechneten Reichweite in Abhängigkeit von einer äußeren Umgebung des Kraftfahrzeugs, insbesondere von der Tatsache, ob sich das Fahrzeug in einer Garage befindet, angesprochen wird, wobei der Umstand, ob sich das Fahrzeug in einer Garage befindet, über mittels eines Außenlufttemperatursensors erfasste Temperaturprofile ermittelt wird.

DE10 2014 118 118 A1 beschreibt eine Degradation eines wiederaufladbaren Engergiespeichers unter Berücksichtigung der Frage, ob sich das Fahrzeug draussen oder drinnen, wie beispielsweise in einer Garage befindet. Der Erfindung liegt die Aufgabe zugrunde, ein verbessertes Verfahren zum Anpassen einer Reichweitenprädiktion sowie ein verbessertes Kraftfahrzeug bereitzustellen.

Die Aufgabe wird gelöst, indem die Gegenstände der unabhängigen Ansprüche geschaffen werden. Vorteilhafte Ausgestaltungen ergeben sich aus den Unteransprüchen.

Die Aufgabe wird insbesondere gelöst, indem ein Verfahren zum Anpassen einer Reichweitenprädiktion eines Kraftfahrzeugs anhand von Umgebungsbedingungen geschaffen wird, wobei eine Außentemperatur erfasst wird, und wobei wenigstens ein Umgebungssensor verwendet wird, um eine räumliche Umgebung des Kraftfahrzeugs zu erfassen. Dabei ist vorgesehen, dass die Reichweitenprädiktion für das Kraftfahrzeug anhand der erfassten Außentemperatur und anhand der erfassten räumlichen Umgebung angepasst wird. Über die Erfassung der räumlichen Umgebung ist es möglich, insbesondere Veränderungen der räumlichen Umgebung des Kraftfahrzeugs zu ermitteln und die Reichweitenprädiktion in unmittelbarem zeitlichem Zusammenhang zu der Änderung der räumlichen Umgebung anzupassen. Hierdurch wird eine zeitliche Verzögerung aufgrund der nur langsamen Änderung eines Messwerts der Außentemperatur vermieden, sodass ein Zusammenhang und/oder eine Ursache für die Anpassung der Reichweitenprädiktion zum Zeitpunkt der Anpassung für den Fahrer des Kraftfahrzeugs erkennbar ist. Durch die Hinzunahme eines der räumlichen Umgebung des Kraftfahrzeugs zugeordneten Messsignals zu der Reichweitenprädiktion steht zudem ein von dem Messwert der Außentemperatur unabhängiger Parameter zur Verfügung, mit welchem die

Genauigkeit der Reichweitenprädiktion erhöht werden kann. Dadurch kann diese insbesondere auch unter stark divergierenden

Temperaturbedingungen, wie sie im Sommer herrschen, mit erhöhter Zuverlässigkeit arbeiten, sodass Fehlanpassungen reduziert, vorzugsweise vermieden werden. Insgesamt wird der Fahrer so deutlich schneller und zuverlässiger und insbesondere in Zusammenhang mit erkennbaren Änderungen der räumlichen Umgebung des Kraftfahrzeugs über Anpassungen der Reichweitenprädiktion informiert, sodass ein direkter Bezug zu den beobachtbaren Änderungen der räumlichen Umgebung vorhanden ist, und die Information nachvollziehbar wird.

Unter einer Reichweitenprädiktion wird hier insbesondere eine Vorhersage einer maximal verfügbaren Reichweite eines Kraftfahrzeugs, insbesondere eines Elektrofahrzeugs mit elektrischem Antrieb, verstanden. Dabei erfolgt die Reichweitenprädiktion insbesondere abhängig von einer Außentemperatur des Kraftfahrzeugs, weil eine Klimatisierungsleistung zur Klimatisierung eines Innenraums des Kraftfahrzeugs - insbesondere zum Heizen oder zum Kühlen - wesentlich die verfügbare Reichweite bei gegebenem Füll- oder Ladezustand eines Energiespeichers des Kraftfahrzeugs beeinflusst. Weiterhin ist es möglich, dass eine zur Verfügung stehende, entnehmbare Leistung eines Akkumulators des Kraftfahrzeugs temperaturabhängig ist. Eine möglichst genaue Ermittlung und Anzeige einer Reichweite insbesondere für ein Elektrofahrzeug ist eine wesentliche Information, da für den Fahrer sichergestellt sein muss, dass er ein angestrebtes Ziel auch erreichen kann, insbesondere wenn ein Netz von Ladestationen für das Kraftfahrzeug nur eine geringe Abdeckung aufweist und/oder ein Ladevorgang längere Zeit in Anspruch nimmt.

Unter einer Anpassung der Reichweitenprädiktion wird insbesondere verstanden, dass die aufgrund von wenigstens einem ersten Parameter ermittelte Reichweite und/oder die Art der Ermittlung der Reichweite aus dem wenigstens einen ersten Parameter auf der Grundlage wenigstens eines zweiten Parameters, der von dem ersten Parameter verschieden ist, verändert wird. Dabei kann der erste Parameter beispielsweise die Außentemperatur sein, wobei der zweite Parameter beispielsweise ein Signal eines Umgebungssensors sein kann, der geeignet ist, eine räumliche Umgebung des Kraftfahrzeugs zu erfassen. Die Reichweitenprädiktion stützt sich somit nicht nur auf den wenigstens einen ersten Parameter, sondern der wenigstens eine zweite Parameter wird zusätzlich herangezogen, wodurch die Genauigkeit der Reichweitenprädiktion steigt.

Unter einem Umgebungssensor wird ein Sensor verstanden, der eingerichtet ist, um eine räumliche Umgebung des Kraftfahrzeugs, insbesondere eine geometrische Umgebung des Kraftfahrzeugs, zu erfassen. Der Umgebungssensor ist eingerichtet um zu erkennen, ob sich das Kraftfahrzeug in einem Innenraum, insbesondere einem geschlossenen Innenraum, oder im Freien befindet.

Unter einem Umgebungssensor wird weiter insbesondere ein Sensor verstanden, bei dem ein Parameter, zu dessen Beobachtung der Sensor eingerichtet ist, und/oder ein Messsignal des Sensors, zumindest nicht unmittelbar temperaturabhängig, jedenfalls nicht in erster Näherung temperaturabhängig ist/sind. Vorzugsweise ist/sind der Parameter und/oder das Messsignal temperaturunabhängig. Ein solcher Umgebungssensor wird auch als temperaturunabhängiger Umgebungssensor bezeichnet. Beispiele hierfür sind beispielsweise ein abstandsgebender Sensor, insbesondere ein Abstandssensor, oder ein optischer Sensor.

Unter einer räumlichen Umgebung des Kraftfahrzeugs wird insbesondere eine geometrische Umgebung des Kraftfahrzeugs verstanden. Insbesondere wird unter einer räumlichen Umgebung des Kraftfahrzeugs verstanden, ob sich das Kraftfahrzeug in einem Innenraum, beispielsweise einem Gebäude, insbesondere einem geschlossenen Innenraum, oder im Freien befindet.

Gemäß dem Verfahren ist vorgesehen, dass mittels des Umgebungssensors eine Änderung der räumlichen Umgebung des Kraftfahrzeugs erkannt wird, wobei die Reichweitenprädiktion anhand der erfassten Änderung der räumlichen Umgebung angepasst wird. Insbesondere wird mittels des Umgebungssensors bevorzugt erfasst, wenn das Kraftfahrzeug einen Innenraum, insbesondere einen geschlossenen Innenraum, verlässt und in eine freie Umgebung gelangt. Dies ist insbesondere im Sommer typischerweise mit einem deutlichen Temperaturanstieg verbunden, der mit einem Außentemperatursensor allerdings nur verzögert erfassbar ist. Mittels des Umgebungssensors ist die Änderung dagegen unmittelbar erfassbar, sodass die Reichweitenprädiktion in unmittelbarem zeitlichem Zusammenhang mit dem Verlassen des Innenraums angepasst werden kann, sodass der Zusammenhang zwischen der Anpassung der Reichweitenprädiktion und dem Verlassen des Innenraums für den Fahrer erkennbar ist.

Gemäß einer Weiterbildung der Erfindung ist vorgesehen, dass wenigstens ein weiterer Umgebungssensor zur Erfassung der räumlichen Umgebung verwendet wird, wobei der weitere Umgebungssensor von dem Umgebungssensor verschieden ist, und wobei ein Signal des weiteren Umgebungssensors zum Anpassen der Reichweitenprädiktion herangezogen wird. Es ist also vorzugsweise ein erster Umgebungssensor vorgesehen, um eine räumliche Umgebung des Kraftfahrzeugs zu erfassen, wobei die Reichweitenprädiktion auf der Grundlage eines Messsignals des ersten Umgebungssensors angepasst wird. Es ist zusätzlich wenigstens ein zweiter Umgebungssensor zur Erfassung der räumlichen Umgebung vorgesehen, der - insbesondere in Bezug auf einen erfassten Parameter und/oder ein Messprinzip und/oder ein ausgegebenes Messsignal - von dem ersten Umgebungssensor verschieden ist. Das Messsignal des zweiten Sensors wird zusätzlich zu dem Messsignal des ersten Umgebungssensors zum Anpassen der Reichweitenprädiktion herangezogen. Hierdurch kann die Zuverlässigkeit der Anpassung der Reichweitenprädiktion weiter erhöht werden. Außerdem ist es möglich, gegebenenfalls Fehlanpassungen aufgrund des Messsignals des ersten Umgebungssensors mittels des Messsignals des zweiten Umgebungssensors zu korrigieren. Beispielsweise ist es bei einer Ausführungsform des Verfahrens möglich, dass als erster Umgebungssensor ein abstandsgebender Sensor verwendet wird, der einen Aufenthalt eines Kraftfahrzeugs in einem Innenraum durch Detektion von in der Nähe des Kraftfahrzeugs angeordneten Wänden des Innenraums erkennen kann. Solange das Kraftfahrzeug in einem geschlossenen Innenraum, beispielsweise einer Garage, steht oder diese verlässt, kann die Reichweitenprädiktion mittels des Messsignals des ersten Umgebungssensors sinnvoll angepasst werden. Absolviert das Kraftfahrzeug jedoch beispielsweise eine Tunneldurchfahrt, kann es zu einem falschpositiven Messsignal des ersten Umgebungssensors kommen, welcher einen Innenraum erkennt und damit eine Fehlanpassung der Reichweitenprädiktion bewirkt. Um dies zu vermeiden, kann als zweiter Umgebungssensor beispielsweise ein optischer Sensor verwendet werden, dessen Messsignal beispielsweise einer Verkehrsschilderauswertung zugrunde gelegt wird. Anhand des Messsignals des zweiten Umgebungssensors und der Verkehrsschilderauswertung kann eine Tunneldurchfahrt erkannt und eine Fehlanpassung aufgrund des Messsignals des ersten Umgebungssensors verhindert werden, beispielsweise indem die entsprechende Anpassung der Reichweitenprädiktion unterdrückt wird.

Bei einer Tunneldurchfahrt wird bevorzugt die vorher berechnete Reichweite beibehalten, da das Kraftfahrzeug voraussichtlich nicht bis zum Fahrtende nur noch durch Tunnels gefahren wird.

Eine Tunneldurchfahrt ist grundsätzlich vergleichbar mit einem kurzen, zeitlich begrenzten Garagen- oder allgemein Innenraumaufenthalt. Daher wird bei einem solchen kurzen Innenraumaufenthalt vorzugsweise ebenfalls eine Anpassung der Reichweitenprädiktion unterdrückt, insbesondere wenn ein Aufenthalt in einem Innenraum für eine Zeitdauer festgestellt wird, die kleiner ist als eine vorbestimmte Grenzzeitdauer.

Gemäß der Erfindung ist vorgesehen, dass der wenigstens eine Umgebungssensor ausgewählt ist aus einer Gruppe bestehend aus einem abstandsgebenden Sensor oder einem Abstandssensor, insbesondere einem Ultraschallsensor, einem Radarsensor, einem optischen Sensor, insbesondere einer Kamera, und einem Laserscanner. Mithilfe wenigstens eines dieser Umgebungssensoren können schnelle und zuverlässige Informationen über die räumliche Umgebung des Kraftfahrzeugs ermittelt werden, die zur Anpassung der Reichweitenprädiktion zur Verfügung stehen und herangezogen werden können.

Insbesondere wenn der wenigstens eine Umgebungssensor als optischer Sensor ausgebildet ist, ist diesem bevorzugt eine Verkehrsschilderauswertung zugeordnet, mittels der eine Schildererkennung von Verkehrsschildern durchgeführt wird. Hierüber können Erkenntnisse über die räumliche Umgebung des Kraftfahrzeugs erhalten werden, die zur Anpassung der Reichweitenprädiktion herangezogen werden können. Wird mittels einer solchen Verkehrsschilderauswertung beispielsweise eine Tunneldurchfahrt erkannt, kann dieses Ergebnis auch verwendet werden, um eine Fehlanpassung der Reichweitenprädiktion aufgrund einer Änderung der Außentemperatur zu verhindern. Typischerweise herrscht nämlich in einem Tunnel eine andere Temperatur als außerhalb des Tunnels, sodass ohne die Erkennung der Tunneldurchfahrt eine Anpassung der Reichweitenprädiktion durch Veränderung des Messsignals eines Außentemperatursensors durchgeführt würde. Da typischerweise eine Tunneldurchfahrt jedoch einen kleinen Teil einer Gesamtfahrstrecke ausmacht, wirkt sich die veränderte Außentemperatur auf die tatsächliche Reichweite nicht oder höchstens marginal aus. Daher kann eine außentemperaturgesteuerte Anpassung der Reichweitenprädiktion vorzugsweise aufgrund der Verkehrsschilderauswertung unterbunden oder unterdrückt werden.

Gemäß einer Weiterbildung der Erfindung ist vorgesehen, dass mittels des Umgebungssensors ein Aufenthalt des Kraftfahrzeugs in einem Gebäude erkannt wird. Insbesondere wird mittels des Umgebungssensors bevorzugt ein Aufenthalt des Kraftfahrzeugs in einer Garage erkannt. Alternativ oder zusätzlich wird mittels des Umgebungssensors vorzugsweise ein Verlassen des Gebäudes, insbesondere ein Verlassen der Garage, durch das Kraftfahrzeug erkannt. Vorzugsweise umfasst das Verfahren also eine Gebäude- und insbesondere eine Garagenerkennung. Wird eine Garage erkannt und das Fahrzeug wird abgestellt, kann beim Verlassen der Garage in engem zeitlichen Zusammenhang zu diesem Ereignis eine Anpassung der Reichweitenprädiktion durchgeführt werden. Die Information, ob das Fahrzeug bei Fahrtantritt in einem Gebäude, insbesondere einer Garage, stand, wird demnach bevorzugt verwendet, um dadurch Parameter für die Beobachtung einer Außentemperatur und insbesondere eines Außentemperaturgradienten zu beeinflussen. Hierüber kann die Reichweitenprädiktion ohne Verzögerung angepasst werden.

Die Information, ob sich das Kraftfahrzeug momentan in einem Gebäude, insbesondere einer Garage, befindet, wird bevorzugt mittels einer Mehrzahl von Umgebungssensoren ermittelt, insbesondere mittels zweier voneinander unabhängiger und voneinander verschiedener Umgebungssensoren, beispielsweise einem Abstandssensor und einem optischen Sensor.

Gemäß der Erfindung ist vorgesehen, dass die Reichweitenprädiktion anhand der Außentemperatur ermittelt wird. Dabei stellt die Außentemperatur - wie bereits zuvor erläutert - eine wesentliche Größe dar, welche die Reichweite des Kraftfahrzeugs bestimmt.

Zusätzlich wird die Reichweitenprädiktion vorzugsweise anhand eines momentanen Leistungsbedarfs des Kraftfahrzeugs ermittelt. Dabei ist offensichtlich, dass der momentane Leistungsbedarf einen Einfluss auf die Reichweite des Kraftfahrzeugs hat. Auch der Leistungsbedarf muss dabei allerdings über einen nicht zu kurzen Zeitraum beobachtet und gemittelt werden, um eine zuverlässige Aussage zur Bestimmung der maximalen Reichweite zu erhalten.

Gemäß einer Weiterbildung der Erfindung ist vorgesehen, dass die Reichweitenprädiktion anhand eines Temperaturgradienten der Außentemperatur angepasst wird. Zusätzlich wird die Reichweitenprädiktion bevorzugt anhand eines Leistungsgradienten des Leistungsbedarfs angepasst. Besonders bevorzugt ist/sind für den Temperaturgradienten und/oder den Leistungsgradienten ein erster Schwellenwert/erste Schwellenwerte definiert, wobei die Reichweitenprädiktion angepasst wird, wenn wenigstens einer der Gradienten - insbesondere mit seinem Betrag - den ihm zugeordneten ersten Schwellenwert erreicht oder überschreitet. Dagegen erfolgt bevorzugt keine Anpassung, wenn beide Gradienten oder ein allein für die Reichweitenprädiktion herangezogener Gradient den jeweils zugeordneten ersten Schwellenwert - insbesondere betragsmäßig - nicht überschreitet. Durch geeignete Wahl der ersten Schwellenwerte kann eine zu häufige Anpassung der Reichweitenprädiktion vermieden und deren Genauigkeit gesteigert werden.

Gemäß einer Weiterbildung der Erfindung ist vorgesehen, dass ein Schwellenwert für den Temperaturgradienten und/oder für den Leistungsgradienten anhand der erfassten räumlichen Umgebung verändert wird. Beispielsweise kann ein erster Schwellenwert auf der Grundlage der erfassten räumlichen Umgebung und insbesondere auf der Grundlage einer Veränderung der erfassten räumlichen Umgebung herabgesetzt werden auf einen zweiten Schwellenwert, sodass ein kleinerer Gradient genügt, um eine Anpassung der Reichweitenprädiktion zu bewirken. Es kann dann beispielsweise beim Verlassen einer Garage ein niedrigerer Gradient im Leistungsbedarf und/oder in der Außentemperatur ausreichen, um die Reichweitenprädiktion anzupassen, sodass die Anpassung schneller und in zeitlichem Zusammenhang mit dem Verlassen der Garage erfolgt. Fehlerhafte Erkennungen können reduziert werden, da in übrigen Situationen, insbesondere bei unveränderter räumlicher Umgebung, ganz besonders bei Erkennung eines Aufenthalts des Kraftfahrzeugs im Freien, der Schwellenwert für den Gradienten wieder nach oben, insbesondere auf den ersten Schwellenwert, gesetzt werden kann, um zu häufige Anpassungen und Fehlanpassungen der Reichweitenprädiktion zu unterdrücken. Es können also insbesondere Parameter für die Beobachtung eines Temperatur- und/oder Leistungsgradienten anhand der Erfassung der räumlichen Umgebung beeinflusst werden, wobei die Empfindlichkeit des Algorithmus zur Reichweitenprädiktion festgelegt werden kann.

Die Aufgabe wird auch gelöst, indem ein Kraftfahrzeug geschaffen wird, welches eingerichtet ist zur Durchführung eines Verfahrens nach einer der zuvor beschriebenen Ausführungsformen. In Zusammenhang mit dem Kraftfahrzeug ergeben sich insbesondere die Vorteile, die bereits in Zusammenhang mit dem Verfahren erläutert wurden.

Das Kraftfahrzeug weist einen Außentemperatursensor zur Erfassung einer Außentemperatur des Kraftfahrzeugs und wenigstens einen Umgebungssensor zur Erfassung einer räumlichen Umgebung des Kraftfahrzeugs auf. Weiterhin weist das Kraftfahrzeug bevorzugt eine Reichweitenprädiktionseinrichtung auf, die eingerichtet ist, um zumindest anhand der erfassten Außentemperatur, insbesondere anhand eines Temperaturgradienten, eine maximale Reichweite des Kraftfahrzeugs vorherzusagen. Die Reichweitenprädiktionseinrichtung ist eingerichtet, um anhand eines Messsignals des Umgebungssensors eine Anpassung der Reichweitenprädiktion vorzunehmen.

Gemäß einer Weiterbildung der Erfindung ist vorgesehen, dass das Kraftfahrzeug als Elektrofahrzeug, insbesondere als Kraftfahrzeug mit elektrischem Antrieb, ausgebildet ist. In Zusammenhang mit einem Elektrofahrzeug verwirklichen sich in besonderer Weise die bereits zuvor beschriebenen Vorteile.

Die Beschreibung des Verfahrens einerseits sowie des Kraftfahrzeugs andererseits sind komplementär zueinander zu verstehen. Merkmale des Kraftfahrzeugs, die explizit oder implizit in Zusammenhang mit dem Verfahren beschrieben wurden, sind bevorzugt einzeln oder miteinander kombiniert Merkmale eines bevorzugten Ausführungsbeispiels des Kraftfahrzeugs. Verfahrensschritte, die explizit oder implizit in Zusammenhang mit dem Kraftfahrzeug beschrieben wurden, sind bevorzugt einzeln oder miteinander kombiniert Schritte einer bevorzugten Ausführungsform des Verfahrens. Dieses zeichnet sich bevorzugt durch wenigstens einen Verfahrensschritt aus, welcher durch wenigstens ein Merkmal eines erfindungsgemäßen oder bevorzugten Ausführungsbeispiels des Kraftfahrzeugs bedingt ist. Das Kraftfahrzeug zeichnet sich bevorzugt durch wenigstens ein Merkmal aus, welches durch wenigstens einen Schritt einer erfindungsgemäßen oder bevorzugten Ausführungsform des Verfahrens bedingt ist.

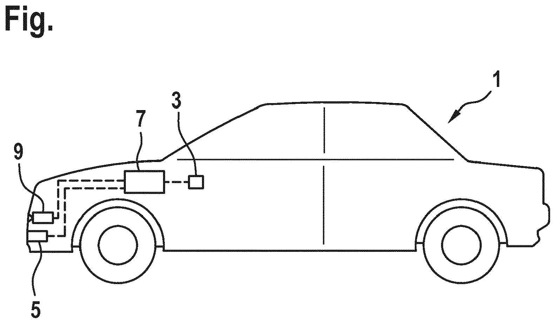

Die Erfindung wird im Folgenden anhand der Zeichnung näher erläutert. Dabei zeigt die einzige Figur eine schematische Darstellung eines Kraftfahrzeugs.

Die einzige Figur zeigt eine schematische Darstellung eines Ausführungsbeispiels eines Kraftfahrzeugs 1, das eingerichtet ist zur Durchführung einer Ausführungsform eines Verfahrens zum Anpassen einer Reichweitenprädiktion des Kraftfahrzeugs 1 anhand von Umgebungsbedingungen. Das Kraftfahrzeug 1 ist vorzugsweise als Elektrofahrzeug ausgebildet.

Es weist einen - vorzugsweise geschützt verbauten - Außentemperatursensor 3 auf, der eingerichtet ist zur Erfassung einer Außentemperatur des Kraftfahrzeugs 1. Es weist weiterhin einen ersten Umgebungssensor 5 auf, der eingerichtet ist, um eine räumliche Umgebung des Kraftfahrzeugs 1 zu erfassen. Der erste Umgebungssensor 5 ist insbesondere ein temperaturunabhängiger Umgebungssensor. Der Umgebungssensor ist aus einer Gruppe bestehend aus einem abstandsgebenden Sensor, einem Abstandssensor, einem Ultraschallsensor, einem Radarsensor, einem optischen Sensor, einer Kamera, und einem Laserscanner ausgewählt. Der Außentemperatursensor 3 und der erste Umgebungssensor 5 sind mit einer Reichweitenprädiktionseinrichtung 7 wirkverbunden, die eingerichtet ist, um eine Reichweitenprädiktion für das Kraftfahrzeug 1 anhand der erfassten Außentemperatur durchzuführen. Die Reichweitenprädiktion 7 ist außerdem eingerichtet, anhand der erfassten Außentemperatur und der erfassten räumlichen Umgebung die Reichweitenprädiktion anzupassen.

Die Reichweitenprädiktionseinrichtung 7 ist vorzugsweise eingerichtet, um der Reichweitenprädiktion zusätzlich einen momentanen Leistungsbedarf des Kraftfahrzeugs 1 zugrunde zu legen. Insbesondere ist die Reichweitenprädiktionseinrichtung 7 bevorzugt eingerichtet, um anhand eines Temperaturgradienten der Außentemperatur sowie vorzugsweise eines Leistungsgradienten des Leistungsbedarfs die Reichweitenprädiktion anzupassen, wobei vorzugsweise die Anpassung der Reichweitenprädiktion anhand der erfassten räumlichen Umgebung angepasst wird. Insbesondere wird bevorzugt durch die Reichweitenprädiktionseinrichtung 7 ein Schwellenwert für den Temperaturgradienten der Außentemperatur und/oder den Leistungsgradienten des Leistungsbedarfs zur Anpassung der Reichweitenprädiktion anhand der erfassten räumlichen Umgebung verändert.

Die Reichweitenprädiktionseinrichtung 7 ist weiterhin eingerichtet, um mittels des Umgebungssensors 5 eine Änderung der räumlichen Umgebung des Kraftfahrzeugs 1 zu erkennen, wobei die Reichweitenprädiktion anhand der Änderung der räumlichen Umgebung angepasst wird.

Es ist ein zweiter Umgebungssensor 9 vorgesehen, der in Hinblick auf einen erfassten Parameter und/oder ein Messsignal von dem ersten Umgebungssensor 5 verschieden ist. Auch der zweite Umgebungssensor 9 wird zur Erfassung der räumlichen Umgebung des Kraftfahrzeugs 1 verwendet. Ein Signal des zweiten Umgebungssensors 9 wird zum Anpassen der Reichweitenprädiktion durch die Reichweitenprädiktionseinrichtung 7 herangezogen, wobei diese mit dem zweiten Umgebungssensor 9 wirkverbunden ist.

Der zweite Umgebungssensor 9 ist vorzugsweise als optischer Sensor, insbesondere als Kamera oder als Laserscanner ausgebildet. Es ist möglich, dass dem zweiten Umgebungssensor 9 und/oder der Reichweitenprädiktionseinrichtung 7 eine Verkehrsschilderauswertung zugeordnet ist, mit der eine Schildererkennung durchgeführt wird. Dabei ist es möglich, anhand erkannter Verkehrsschilder auf die räumliche Umgebung des Kraftfahrzeugs 1 zu schließen und diese Information für die Anpassung der Reichweitenprädiktion heranzuziehen.

Mittels der Umgebungssensoren 5, 9 wird insbesondere ein Aufenthalt des Kraftfahrzeugs 1 in einem Gebäude, insbesondere einer Garage erkannt. Zusätzlich oder alternativ wird bevorzugt ein Verlassen des Gebäudes, insbesondere der Garage, durch das Kraftfahrzeug 1 mittels der Umgebungssensoren 5, 9 erkannt.

Insgesamt zeigt sich, dass mithilfe des Verfahrens und bei dem Kraftfahrzeug 1 eine zuverlässige, verzögerungsfreie Anpassung einer Reichweitenprädiktion insbesondere bei einer Veränderung einer räumlichen Umgebung des Kraftfahrzeugs 1 möglich ist.

## Patentansprüche

1. Verfahren zum Anpassen einer Reichweitenprädiktion eines Kraftfahrzeugs (1) anhand von Umgebungsbedingungen, wobei
- eine Außentemperatur erfasst wird, und wobei
- wenigstens ein Umgebungssensor (5,9) verwendet wird, der ausgewählt ist aus einer Gruppe bestehend aus einem abstandsgebenden Sensor, einem Abstandssensor, einem Ultraschallsensor, einem Radarsensor, einem optischen Sensor, einer Kamera, und einem Laserscanner, um eine räumliche Umgebung des Kraftfahrzeugs (1) zu erfassen, wobei
- mittels des wenigstens einen Umgebungssensors (5,9) erfasst wird, ob sich das Kraftfahrzeug in einem Innenraum oder im Freien befindet, wobei
- eine Reichweitenprädiktion für das Kraftfahrzeug (1) anhand der erfassten Außentemperatur und der erfassten räumlichen Umgebung angepasst wird, und wobei
- mittels des Umgebungssensors (5,9) eine Änderung der räumlichen Umgebung des Kraftfahrzeugs (1) erkannt wird, wobei die Reichweitenprädiktion anhand der erkannten Änderung der räumlichen Umgebung angepasst wird.

2. Verfahren nach Anspruch 1, **dadurch gekennzeichnet, dass** wenigstens ein weiterer Umgebungssensor (9) zur Erfassung der räumlichen Umgebung verwendet wird, wobei der weitere Umgebungssensor (9) von dem Umgebungssensor (5) verschieden ist, wobei ein Messsignal des weiteren Umgebungssensors (5,9) zum Anpassen der Reichweitenprädiktion herangezogen wird.

3. Verfahren nach einem der vorhergehenden Ansprüche, **dadurch gekennzeichnet, dass** mittels des Umgebungssensors (5,9) ein Aufenthalt des Kraftfahrzeugs (1) in einem Gebäude und/oder ein Verlassen eines Gebäudes durch das Kraftfahrzeug (1) erkannt wird.

4. Verfahren nach einem der vorhergehenden Ansprüche, **dadurch gekennzeichnet, dass** die Reichweitenprädiktion anhand der Außentemperatur und vorzugsweise anhand eines momentanen Leistungsbedarfs des Kraftfahrzeugs (1) ermittelt wird.

5. Verfahren nach einem der vorhergehenden Ansprüche, **dadurch gekennzeichnet, dass** die Reichweitenprädiktion anhand eines Temperaturgradienten der Außentemperatur und vorzugsweise anhand eines Leistungsgradienten des Leistungsbedarfs angepasst wird, wobei die Anpassung der Reichweitenprädiktion vorzugsweise anhand der erfassten räumlichen Umgebung korrigiert wird.

6. Verfahren nach einem der vorhergehenden Ansprüche, **dadurch gekennzeichnet, dass** ein Schwellenwert für den Temperaturgradienten der Außentemperatur und/oder ein Schwellenwert für den Leistungsgradienten des Leistungsbedarfs anhand der erfassten räumlichen Umgebung verändert wird.

7. Kraftfahrzeug (1), mit einem Außentemperatursensor (3) zur Erfassung einer Außentemperatur, wenigstens einem Umgebungssensor (5,9) zur Erfassung einer räumlichen Umgebung des Kraftfahrzeugs (1), der ausgewählt ist aus einer Gruppe bestehend aus einem abstandsgebenden Sensor, einem Abstandssensor, einem Ultraschallsensor, einem Radarsensor, einem optischen Sensor, einer Kamera, und einem Laserscanner, und mit einer Reichweitenprädiktionseinrichtung (7), die eingerichtet ist, um zumindest anhand der erfassten Außentemperatur eine maximale Reichweite des Kraftfahrzeugs (1) vorherzusagen, und um anhand eines Messsignals des Umgebungssensors (5,9) eine Anpassung der Reichweitenprädiktion vorzunehmen, wobei das Kraftfahrzeug (1) eingerichtet zur Durchführung eines Verfahrens nach einem der Ansprüche 1 bis 6 ist.

8. Kraftfahrzeug (1) nach Anspruch 7, **dadurch gekennzeichnet, dass** das Kraftfahrzeug (1) als Elektrofahrzeug ausgebildet ist.

## Claims

1. Method for adjusting a range prediction of a motor vehicle (1) on the basis of environmental conditions, wherein
- an external temperature is detected and wherein
- at least one environment sensor (5, 9) is used, which is selected from a group consisting of a distance-indicating sensor, a distance sensor, an ultrasound sensor, a radar sensor, an optical sensor, a camera and a laser scanner in order to determine a spatial environment of the motor vehicle (1), wherein
- it is detected by means of the at least one environment sensor (5, 9) whether the motor vehicle is located in an internal space or an outside space, wherein
- a range prediction for the motor vehicle (1) is adjusted on the basis of the detected external temperature and the detected spatial environment, and wherein
- by means of the environment sensor (5, 9) a change is recognised in the spatial environment of the motor vehicle (1), wherein the range prediction is adjusted on the basis of the recognised change in the spatial environment.

2. Method according to claim 1, **characterised in that** at least one additional environmental sensor (9) is used for detecting the spatial environment, wherein the additional environment sensor (9) is different from the environment sensor (5), wherein a measurement signal of the additional environment sensor (5, 9) is used for adjusting the range prediction.

3. Method according to any of the preceding claims, **characterised in that** by means of the environment sensor (5, 9) the presence of the motor vehicle (1) in a building and/or a departure of the motor vehicle (1) from the building is detected.

4. Method according to any of the preceding claims, **characterised in that** the range prediction is determined on the basis of the external temperature and preferably on the basis of a current power requirement of the motor vehicle (1).

5. Method according to any of the preceding claims, **characterised in that** the range prediction is adjusted on the basis of a temperature gradient of the external temperature and preferably on the basis of a power gradient of the power requirement, wherein the adjustment of the range prediction is preferably corrected on the basis of the detected spatial environment.

6. Method according to any of the preceding claims, **characterised in that** a threshold for the temperature gradient of the external temperature and/or a threshold for the power gradient of the power requirement is adjusted on the basis of the detected spatial environment.

7. Motor vehicle (1) with an external temperature sensor (3) for detecting an external temperature, at least one environment sensor (5, 9) for detecting a spatial environment of the motor vehicle (1), which is selected from a group consisting of a distance-indicating sensor, a distance sensor, an ultrasound sensor, a radar sensor, an optical sensor, a camera and a laser scanner, and with a range prediction device (7) which is configured to predict at least on the basis of the detected external temperature a maximum range of the motor vehicle (1) and to make an adjustment of the range prediction on the basis of a measurement signal of the environment sensor (5, 9), wherein the motor vehicle (1) is configured to perform a method according to any of claims 1 to 6.

8. Motor vehicle (1) according to claim 7, **characterised in that** the motor vehicle (1) is configured as an electric vehicle.

## Revendications

1. Procédé d'adaptation d'une prédiction de portée d'un véhicule automobile (1) au moyen de conditions ambiantes, dans lequel
- une température extérieure est détectée, et dans lequel
- au moins un capteur d'environnement (5, 9) est utilisé, lequel est sélectionné à partir d'un groupe constitué par un capteur d'espacement, un capteur de distance, un capteur à ultrasons, un capteur radar, un capteur optique, une caméra et un scanner laser, pour détecter un environnement spatial du véhicule automobile (1), dans lequel
- le au moins un capteur d'environnement (5, 9) permet de détecter si le véhicule automobile se trouve dans un espace intérieur ou en extérieur, dans lequel
- une prédiction de portée pour le véhicule automobile (1) est adaptée au moyen de la température extérieure détectée et de l'environnement spatial détecté, et dans lequel
- le capteur d'environnement (5, 9) permet de détecter une modification de l'environnement spatial du véhicule automobile (1), la prédiction de portée étant adaptée au moyen de la modification détectée de l'environnement spatial.

2. Procédé selon la revendication 1, **caractérisé en ce qu'**
au moins un autre capteur d'environnement (9) est utilisé pour la détection de l'environnement spatial, dans lequel l'autre capteur d'environnement (9) est différent du capteur d'environnement (5), un signal de mesure de l'autre capteur d'environnement (5, 9) étant mis en œuvre pour l'adaptation de la prédiction de portée.

3. Procédé selon l'une quelconque des revendications précédentes, **caractérisé en**
**ce que** le capteur d'environnement (5, 9) permet de détecter un stationnement du véhicule automobile (1) dans un bâtiment et/ou un départ du véhicule automobile (1) hors d'un bâtiment.

4. Procédé selon l'une quelconque des revendications précédentes, **caractérisé en**
**ce que** la prédiction de portée est déterminée au moyen de la température extérieure et de préférence au moyen d'une exigence de puissance momentanée du véhicule automobile (1).

5. Procédé selon l'une quelconque des revendications précédentes, **caractérisé en ce que** la prédiction de portée est adaptée au moyen d'un gradient de température de la température extérieure et de préférence au moyen d'un gradient de puissance de l'exigence de puissance, l'adaptation de prédiction de portée étant corrigée de préférence au moyen de l'environnement spatial détecté.

6. Procédé selon l'une quelconque des revendications précédentes, **caractérisé en ce qu'**une valeur seuil pour le gradient de température de la température extérieure et/ou une valeur seuil pour le gradient de puissance de l'exigence de puissance est modifiée au moyen de l'environnement spatial détecté.

7. Véhicule automobile (1), équipé d'un capteur de température extérieure (3) pour la détection d'une température extérieure, d'au moins un capteur d'environnement (5, 9) pour la détection d'un environnement spatial du véhicule automobile (1) qui est sélectionné à partir d'un groupe constitué par un capteur d'espacement, un capteur de distance, un capteur à ultrasons, un capteur radar, un capteur optique, une caméra et un scanner laser, et doté d'un dispositif de prédiction de portée (7) qui est configuré pour prévoir au moins au moyen de la température extérieure détectée une portée maximale du véhicule automobile (1), et pour entreprendre une adaptation de la prédiction de portée au moyen d'un signal de mesure du capteur d'environnement (5, 9), le véhicule automobile (1) étant configuré pour réaliser un procédé selon l'une quelconque des revendications 1 à 6.

8. Véhicule automobile (1) selon la revendication 7, **caractérisé en ce que** le véhicule automobile (1) est conçu comme un véhicule électrique.
